# EUROPEAN PATENT APPLICATION

(11) **EP 4 354 724 A1**
(43) Date of publication of application: **17.04.2024**
(21) Application number: 22841826.5
(22) Date of filing: 01.06.2022
(51) Int. Cl.: H02M 7/48

(54) **POWER CONVERSION DEVICE**

(30) Priority: 14.07.2021 JP 2021116242
(71) Applicant: Mitsubishi Heavy Industries, Ltd., Tokyo 100-8332 (JP)
(72) Inventor: NAKAGAMI, Takashi, Tokyo 100-8332 (JP); UMEMOTO, Soichiro, Tokyo 100-8332 (JP); YOSHINO, Yusuke, Tokyo 100-8332 (JP)
(74) Representative: Studio Torta S.p.A.
(86) International application number: PCT/JP2022/022253
(87) International publication number: WO 2023/286479

(57) **Abstract**

A power conversion device comprising: a housing having an accommodating space formed therein; a base substrate fixed onto an inner surface of the housing so that the accommodating space is partitioned into a first space on a first side and a second space on a second side; a first substrate stacked on a part of a main surface of the base substrate facing the first side, the first substrate having a power semiconductor element; and a second substrate disposed opposite the base substrate and the first substrate so as to be spaced apart from the base substrate and the first substrate with a space on the first side, the second substrate being fixed onto the inner surface of the housing and having a gate drive circuit for inputting a gate voltage to the power semiconductor element via a connection conductor.

## Description

### Technical Field

The present disclosure relates to a power conversion device.

This application claims priority to Japanese Patent Application No. 2021-116242, filed in Japan on July 14, 2021, the content of which is incorporated herein by reference.

### Background Art

PTL 1 discloses a power module in which a power semiconductor element is built, and a power conversion device including a gate drive substrate for controlling switching of the power module. An electronic component (gate driver IC or the like) in a gate drive circuit of the gate drive substrate may have lower heat resistance as compared with the power semiconductor element. Therefore, in order to realize an increase in the current of the power conversion device, there is a demand for a technique of making it difficult for the heat of the power semiconductor element to be conducted to the gate drive substrate.

In the power conversion device described in PTL 1, a cooler is interposed between the gate drive substrate and the power module. As a result, conduction of heat from the power module to the gate drive substrate is difficult to occur, and a temperature rise of the gate drive substrate is suppressed.

### Citation List

### Patent Literature

[PTL 1] Japanese Unexamined Patent Application Publication No. 2012-105419

### Summary of Invention

### Technical Problem

In PTL 1, a cooler is interposed between a gate drive substrate and a power module. Therefore, a wiring (connecting conductor) for connecting the gate drive substrate and the power module to transmit a control signal from the gate drive substrate to the power semiconductor element becomes longer by a dimension of the cooler. Therefore, while it is possible to suppress the conduction of heat from the power semiconductor element to the gate drive circuit, there is a possibility that a wiring inductance generated in this wiring may increase, at least for the dimension of the cooler.

The purpose of the present disclosure is to solve the above problems, and to provide a power conversion device capable of reducing a wiring inductance of a connecting conductor while suppressing conduction of heat from a power semiconductor element to a gate drive circuit.

### Solution to Problem

In order to solve the above problems, a power conversion device according to the present disclosure includes a housing which forms an accommodation space therein, a base substrate which is fixed to an inner surface of the housing such that the accommodation space is partitioned into a first space on a first side and a second space on a second side, a first substrate which is mounted on a part of a main surface of the base substrate facing the first side, and including a power semiconductor element, and a second substrate which is disposed to face the base substrate and the first substrate such that the second substrate is separated from the base substrate and the first substrate with a space on the first side, is fixed to the inner surface of the housing, and includes a gate drive circuit which inputs a gate voltage to the power semiconductor element via a connecting conductor.

### Advantageous Effects of Invention

According to the present disclosure, it is possible to provide a power conversion device capable of reducing a wiring inductance of a connecting conductor while suppressing conduction of heat from a power semiconductor element to a gate drive circuit.

### Brief Description of Drawings

Fig. 1 is a perspective view illustrating a schematic configuration of a power conversion device according to an embodiment of the present disclosure.
Fig. 2 is a perspective view illustrating a schematic configuration of a power module according to an embodiment of the present disclosure.
Fig. 3 is a sectional view taken along line III-III in Fig. 1.

### Description of embodiments

### (Power conversion device)

Hereinafter, a power conversion device according to the present embodiment will be described with reference to the drawings.

The power conversion device of the present embodiment is a device that converts DC power into three-phase AC power or the like. Examples of the power conversion device of the present embodiment include an inverter used in a system of a power plant or the like, and an inverter used for driving an electric motor of an electric vehicle or the like. In the present embodiment, an inverter for controlling an electric motor as a power conversion device will be described as an example.

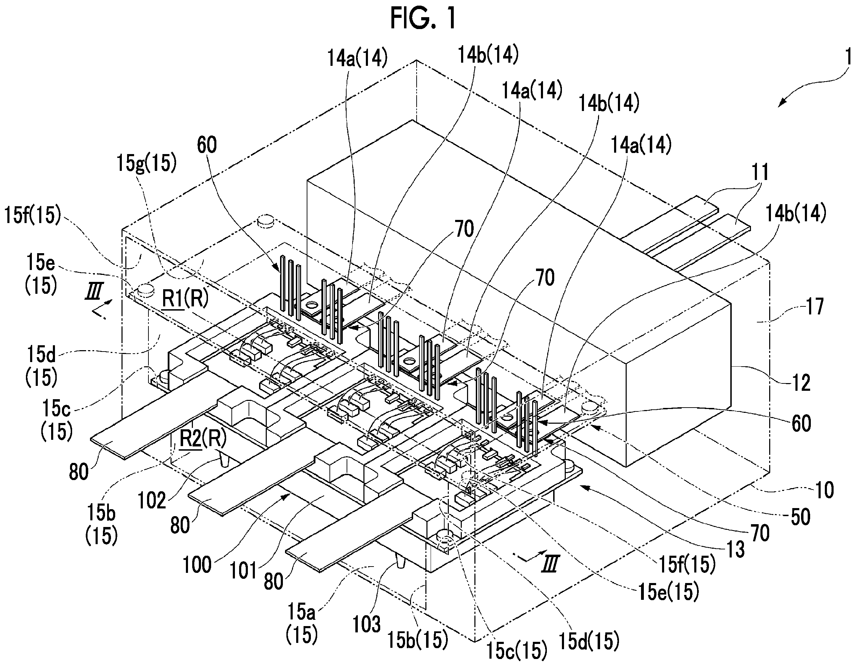

As shown in Fig. 1, the power conversion device 1 includes a housing 10, an external input conductor 11, a rectification unit 12, a power conversion unit 13, a relay conductor 14, and a cooler 100.

### (Housing)

The housing 10 forms an outer shell of the power conversion device 1. The housing 10 illustrated in the present embodiment is formed of a synthetic resin or the like and has a rectangular shape. The housing 10 has an inner surface 15 forming an accommodation space R inside. The housing 10 in Fig. 1 is indicated by a two-point chain line.

As shown in Figs. 1 to 3, the inner surface 15 of the housing 10 includes a bottom surface 15a, a top surface 15g, a side surface 17 on an input side, a side surface on an output side (not shown), a first side surface 15b, a first fixing surface 15c, a second side surface 15d, a second fixing surface 15e, and a third side surface 15f.

The bottom surface 15a forms a bottom surface portion of the inner surface 15 forming the accommodation space R. The top surface 15g forms a ceiling portion facing the bottom surface 15a of the inner surface 15 forming the accommodation space R.

The side surface 17 on the input side and the side surface on the output side are surfaces connecting the bottom surface 15a and the top surface 15g, and form a side surface portion of the inner surface 15 forming the accommodation space R. For example, a conductor for inputting a DC power to be an input of the power conversion device 1 penetrates the side surface 17 on the input side and extends from the accommodation space R toward the outside of the housing 10. For example, a conductor for outputting AC power to be an output of the power conversion device 1 penetrates the side surface on the output side and extends from the accommodation space R toward the outside of the housing 10. The side surface on the output side faces the side surface 17 on the input side.

The first side surface 15b extends from the bottom surface 15a in a direction perpendicular to the bottom surface 15a. The first side surface 15b forms a side surface portion of the inner surface 15 forming the accommodation space R, and connects the side surface 17 on the input side and the side surface on the output side. More specifically, the inner surface 15 of the housing 10 has a pair of first side surfaces 15b, and the pair of first side surfaces 15b face each other.

The first fixing surface 15c extends from the first side surface 15b in a direction perpendicular to the first side surface 15b, that is, in parallel with the bottom surface 15a, and connects the side surface 17 on the input side and the side surface on the output side. More specifically, the inner surface 15 of the housing 10 has a pair of first fixing surfaces 15c.

The second side surface 15d extends from the first fixing surface 15c in a direction perpendicular to the first fixing surface 15c. The first side surface 15b forms a side surface portion of the inner surface 15 forming the accommodation space R, and connects the side surface 17 on the input side and the side surface on the output side. More specifically, the inner surface 15 of the housing 10 has a pair of second side surfaces 15d, and the pair of second side surfaces 15d face each other.

The second fixing surface 15e extends from the second side surface 15d in a direction perpendicular to the second side surface 15d, that is, in parallel with the bottom surface 15a, and connects the side surface 17 on the input side and the side surface on the output side. More specifically, the inner surface 15 of the housing 10 has a pair of second fixing surfaces 15e.

The third side surface 15f extends from the second fixing surface 15e in a direction perpendicular to the second fixing surface 15e and is connected to the top surface 15g. The third side surface 15f forms a side surface portion of the inner surface 15 forming the accommodation space R, and connects the side surface 17 on the input side and the side surface on the output side. More specifically, the inner surface 15 of the housing 10 has a pair of third side surfaces 15f, and the pair of third side surfaces 15f face each other.

### (External input conductor)

The external input conductor 11 is an electric conductor that guides DC power supplied from the outside of the power conversion device 1 to the accommodation space R inside the housing 10. The external input conductor 11 in the present embodiment is an electric conductor (bus bar) formed of a metal including copper or the like. The external input conductor 11 extends in a direction intersecting the side surface 17 on the input side of the housing 10.

### (Rectification unit)

The rectification unit 12 rectifies the DC power input from the external input conductor 11. The rectification unit 12 in the present embodiment includes a plurality of capacitors (not shown) that remove high-frequency components superimposed on the power input from the external input conductor 11. The rectification unit 12 may be provided as needed, for example, the rectification unit 12 may be omitted.

### (Power conversion unit)

The power conversion unit 13 converts the DC power from which the high-frequency component has been removed by the rectification unit 12, and outputs the three-phase AC power as the AC power.

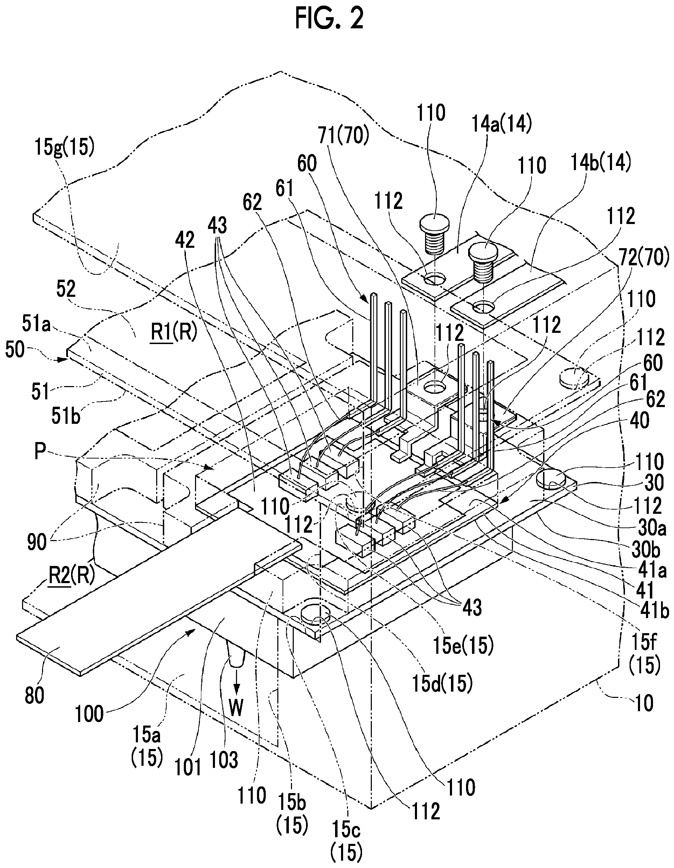

As shown in Figs. 1 and 2, the power conversion unit 13 includes a base substrate 30, a first substrate 40, an input conductor 70, a second substrate 50, a connecting conductor 60, an output conductor 80, and a block body 90. The second substrate 50 and the block body 90 in Fig. 2 are indicated by a two-point chain line.

### (Base substrate)

The base substrate 30 is a member having a flat plate shape. The base substrate 30 has a main surface 30a and a back surface 30b located on a back side of the main surface 30a. The main surface 30a and the back surface 30b of the base substrate 30 are back-to-back in a state of being parallel to each other. For example, copper is adopted for the base substrate 30 in the present embodiment. A metal other than copper may be adopted for the base substrate 30.

The base substrate 30 is fixed to the inner surface 15 of the housing 10. More specifically, fastening holes 112 to which the bolts 110 can be fastened are formed at the four corners of the base substrate 30, and are fixed to the first fixing surface 15c using the bolts 110. The base substrate 30 is fixed to the first fixing surface 15c to partition the accommodation space R into a first space R1 on the first side and a second space R2 on the second side.

It is noted that the accommodation space R in the present embodiment is partitioned into the first side and the second side not only by the base substrate 30, but also partitioned into the first space R1 on the first side and the second space R2 on the second side by a virtual plane extending such that the base substrate 30 is extended.

### (First substrate)

As shown in Fig. 2, the first substrate 40 includes a first substrate main body 41, a power conversion circuit 42, and a power semiconductor element 43.

The first substrate main body 41 has a flat plate shape. The first substrate main body 41 includes a first surface 41a and a second surface 41b located on a back side of the first surface 41a. The first surface 41a and the second surface 41b of the first substrate main body 41 are back-to-back in a state of being parallel to each other. The second surface 41b of the first substrate main body 41 is fixed to the main surface 30a of the base substrate 30 via a weld material or the like. In the present embodiment, the three first substrates 40 are arranged side by side on the main surface 30a of the base substrate 30. More specifically, these first substrates 40 are arranged side by side on the main surface 30a of the base substrate 30 in a direction in which a pair of second side surfaces 15d face each other.

The first substrate main body 41 is formed of, for example, an insulating material such as ceramic. As the insulating material forming the first substrate main body 41, paper phenol, paper epoxy, glass composite, glass epoxy, glass polyimide, fluororesin, or the like can be used in addition to ceramic.

The power conversion circuit 42 is a pattern of a copper foil or the like formed on the first surface 41a of the first substrate main body 41. The power conversion circuit 42 in the present embodiment is formed, for example, by being fixed to the first surface 41a of the first substrate main body 41 by adhesion or the like and then being subjected to etching or the like. An input circuit (not shown) and an output circuit (not shown) are formed in the power conversion circuit 42 of the present embodiment.

The input circuit is a circuit pattern for inputting power input from the outside to the power semiconductor element 43. The output circuit is a circuit pattern for outputting power converted by the power semiconductor element 43.

The power semiconductor element 43 is, for example, a switching element such as an IGBT or a MOSFET. In the present embodiment, the six power semiconductor elements 43 are mounted on the power conversion circuit 42 of the first substrate 40. The power semiconductor element 43 includes an input terminal (not shown), an output terminal (not shown), and a control terminal (not shown). The input terminal of the power semiconductor element 43 is electrically connected to the input circuit of the power conversion circuit 42 formed on the first surface 41a of the first substrate main body 41 via a weld material or the like.

For example, one end of a lead frame (not shown) as a conducting wire is electrically connected to the output terminal of the power semiconductor element 43. The other end of the lead frame is electrically connected to the output circuit of the power conversion circuit 42. That is, a DC current flows into the input terminal (not shown) via the power conversion circuit 42, and the AC current converted by the power semiconductor element 43 is output from the output terminal (not shown). A control signal for controlling switching of the power semiconductor element 43 is input to the control terminal from the outside of the first substrate 40.

For the weld material for bonding between the base substrate 30 and the first substrate main body 41, and between the power semiconductor element 43 and the power conversion circuit 42, for example, a solder or a sintered material (powder of metal, ceramic, or the like) or the like can be adopted.

### (Input conductor)

The input conductor 70 is a current path for receiving a current input from the capacitor of the rectification unit 12 and causing a DC current to flow to the power conversion circuit 42 of the first substrate 40. As shown in Fig. 2, an end portion of the input conductor 70 is electrically connected to a power conversion circuit 42 formed on the first surface 41a of the first substrate main body 41.

The input conductor 70 includes a first input conductor 71 and a second input conductor 72 as two terminals forming the PN terminal. The first input conductor 71 and the second input conductor 72 are arranged side by side at intervals in a direction along the base substrate 30. As shown in Fig. 1, in the present embodiment, each of the three sets of the input conductors 70 is disposed such that corresponds to the first substrate 40.

As shown in Fig. 2, the first input conductor 71 is an electric conductor made of a metal such as copper as a positive electrode that transmits power to the power semiconductor element 43 of the first substrate 40. The second input conductor 72 is an electric conductor made of a metal such as copper as a negative electrode that transmits power to the power semiconductor element 43 of the first substrate 40. Fastening holes 112 to which the bolts 110 can be fastened are formed in the first input conductor 71 and the second input conductor 72.

### (Second substrate)

The second substrate 50 includes a second substrate main body 51 and a gate drive circuit 52.

The second substrate main body 51 has a flat plate shape. The second substrate main body 51 includes a mounting surface 51a and a facing surface 51b located on the back side of the mounting surface 51a. The mounting surface 51a and the facing surface 51b of the second substrate main body 51 are back-to-back in a state of being parallel to each other.

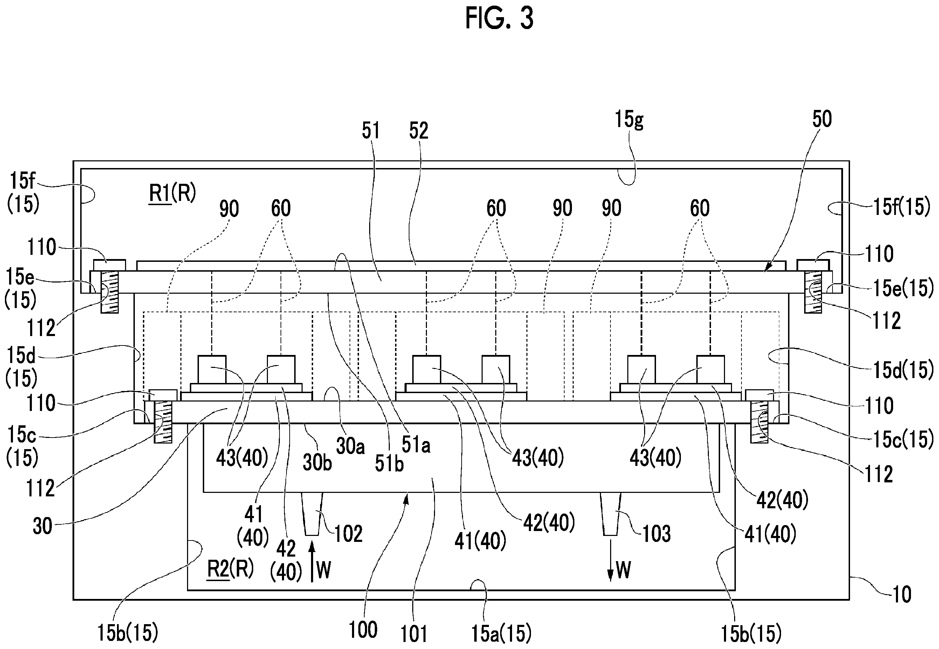

The second substrate main body 51 is fixed to the inner surface 15 of the housing 10. More specifically, a fastening hole 112 to which the bolt 110 can be fastened is formed at an end portion of the second substrate 50, and is fixed, with the bolt 110, to the second fixing surface 15e which faces the first side on a first side closer than the first fixing surface 15c of the inner surface 15 of the housing 10. The second substrate main body 51 is disposed to be separated from the base substrate 30 and the first substrate 40 via a space on the first side, and to face the base substrate 30 and the first substrate 40. Therefore, as shown in Fig. 3, the base substrate 30 and the second substrate 50 are connected to each other only via the housing 10.

The second substrate main body 51 is formed of an insulating material such as glass epoxy. In addition to the glass epoxy, paper phenol, paper epoxy, a glass composite, glass polyimide, a fluororesin, a ceramic, or the like can be used as the material for forming the second substrate main body 51.

The gate drive circuit 52 is a circuit for controlling switching of the power semiconductor element 43. The gate drive circuit 52 is a pattern of copper foil or the like formed on the mounting surface 51a of the second substrate main body 51. In the forming step of the gate drive circuit 52 in the present embodiment, first, a copper foil is formed on the mounting surface 51a of the second substrate main body 51, and then an etching resist is applied onto the surface of the copper foil. After the etching resist is subjected to masking according to a circuit pattern, the gate drive circuit 52 is formed on the second substrate main body 51 by performing exposure, development, etching, or the like. That is, the gate drive circuit 52 is formed on the second substrate main body 51 by the subtractive method.

In the gate drive circuit 52 in the present embodiment, a gate driver IC (not shown) that generates the control signal to be input to the control terminal of the power semiconductor element 43 is mounted. The gate driver IC generates a gate voltage for driving the gate of the power semiconductor element 43. The gate drive circuit 52 inputs (applies) the gate voltage generated by the gate driver IC to the power semiconductor element 43.

### (Connecting conductor)

The connecting conductor 60 is an electric conductor for electrically connecting the gate drive circuit 52 of the second substrate 50 and the power semiconductor element 43 of the first substrate 40, and transmitting the control signal from the gate drive circuit 52 to the power semiconductor element 43. The connecting conductor 60 includes a first connection portion 61 and a second connection portion 62. The connecting conductor 60 in Fig. 3 is indicated by a dotted line.

The first connection portion 61 extends toward the base substrate 30 penetrating the second substrate main body 51 from the gate drive circuit 52 of the second substrate 50, and then is exposed in a potting space P penetrating the block body 90. As shown in Fig. 2, the first connection portion 61 in the present embodiment has an L shape.

The second connection portion 62 is a lead wire that connects the first connection portion 61 and the power semiconductor element 43.

Therefore, the control signal generated by the gate drive circuit 52 via the first connection portion 61 and the second connection portion 62 is input to the control terminal of the power semiconductor element 43.

For example, aluminum is used for the first connection portion 61 and the second connection portion 62 in the present embodiment. In addition, a metal other than aluminum, such as copper, may be adopted for the first connection portion 61 and the second connection portion 62.

The first connection portion 61 and the gate drive circuit 52 of the second substrate 50 in the present embodiment are connected by, for example, soldering (the connection state is not shown). The first connection portion 61 and the gate drive circuit 52 may be connected to each other via a connector or the like. Further, for example, a through hole electrically connected to the gate drive circuit 52 is formed on the second substrate main body 51, and the first connection portion 61 and the gate drive circuit 52 may be connected to each other by press-fitting the first connection portion 61 as a press-fit terminal into the through hole.

### (Output conductor)

The output conductor 80 is an output bus bar for receiving a current output from the power semiconductor element 43 and outputting the current to the outside of the power conversion device 1. One end of the output conductor 80 is electrically connected to the output circuit of the power conversion circuit 42 on the first substrate 40. As shown in Figs. 1 and 2, the other end of the output conductor 80 penetrates the side surface on the output side of the inner surface 15 of the housing 10 and extends to the outside of the housing 10. An output wiring or the like for current output (not shown) is connected to the other end of the output conductor 80. As a result, it becomes possible to output AC power to the outside of the power conversion device 1. As shown in Fig. 1, in the present embodiment, the three output conductors 80 are respectively disposed to correspond to the first substrate 40.

### (Block body)

The block body 90 is a member that is fixed to the main surface 30a of the base substrate 30 and mechanically reinforces the input conductor 70 and the output conductor 80. The block body 90 is formed of a synthetic resin material. The block body 90 covers the first input conductor 71 and the second input conductor 72 from the outside, and surrounds the first substrate 40 from at least the outside. That is, the block body 90 has a frame shape extending along the main surface 30a of the base substrate 30, and accommodates the first substrate 40 inside. Here, the second substrate 50 is provided to be separated from the block body 90 via a space on the first side. The block body 90 in Fig. 3 is indicated by a dotted line.

The block body 90 is fixed to the main surface 30a of the base substrate 30 via an adhesive or the like. For the block body 90 in the present embodiment, for example, an insulating material such as polyphenylene sulfide (PPS) can be adopted as the synthetic resin material. In addition, an insulating material other than PPS may be adopted for the block body 90.

The block body 90 defines a space together with the first substrate 40. In the present embodiment, the space defined by the block body 90 and the first substrate 40 is referred to as a "potting space P". A liquid potting material is poured (potting) into the potting space P from the outside, and at least the power conversion circuit 42 of the first substrate main body 41, the power semiconductor element 43, and a part of the input conductor 70 exposed in the potting space P is sealed.

The potting material poured into the potting space P is cured over a predetermined time, and electrically insulates the power conversion circuit 42 and the power semiconductor element 43 of the first substrate 40 from a space outside of the power module 20. For example, a silicon gel or an epoxy resin can be used as the potting material in the present embodiment. A synthetic resin other than the silicon gel or the epoxy resin may be adopted as the potting material.

### (Relay conductor)

The relay conductor 14 is an electric conductor (bus bar) for transmitting power from the rectification unit 12 to the power conversion unit 13. One end of the relay conductor 14 is connected to the rectification unit 12 (the connection state is not shown). The other end of the relay conductor 14 is connected to the input conductor 70 of the power conversion unit 13.

A fastening hole 112 for fastening the bolt 110 is formed at the other end of the relay conductor 14 in the present embodiment. The other end of the relay conductor 14 is fastened to a fastening hole 112 formed on the input conductor 70 via the bolt 110, and the relay conductor 14 and the input conductor 70 are connected to each other.

The relay conductor 14 includes a first relay conductor 14a and a second relay conductor 14b.

The first relay conductor 14a is a current path that connects the capacitor of the rectification unit 12 and the positive electrode of the input conductor 70 of the power conversion unit 13. The second relay conductor 14b is a current path that connects the capacitor of the rectification unit 12 and the negative electrode of the input conductor 70 of the power conversion unit 13. The first relay conductor 14a and the second relay conductor 14b are arranged side by side.

### (Cooler)

The cooler 100 is a device that cools the base substrate 30 and the first substrate 40 of the power conversion unit 13. The cooler 100 is provided in the second space R2, comes into contact with only the back surface 30b of the base substrate 30 facing the second side, and is provided on the back surface 30b of the base substrate 30 via a weld material or the like. The cooler 100 in the present embodiment includes a cooler main body 101, a refrigerant inlet portion 102, and a refrigerant outlet portion 103.

The cooler main body 101 is bonded to the back surface 30b of the base substrate 30 via a weld material or the like. A flow path through which the refrigerant W flows is formed inside the cooler main body 101. For example, the refrigerant inlet portion 102 guides the refrigerant W supplied from a refrigerant supply device (not shown) provided outside of the power conversion device 1 to the inside of the cooler main body 101. The refrigerant outlet portion 103 discharges the refrigerant W that has flowed from the refrigerant inlet portion 102 and has flowed inside the cooler main body 101 to the outside. The refrigerant W discharged from the refrigerant outlet portion 103 is returned to, for example, the refrigerant supply device.

That is, the heat of the power semiconductor element 43 is conducted to the refrigerant W via the power conversion circuit 42, the first substrate main body 41, the base substrate 30, the cooler main body 101, and the like. Accordingly, the cooler 100 can cool the power semiconductor element 43 of the first substrate 40 and the base substrate 30.

For the bonding between the base substrate 30 and the cooler main body 101, for example, a weld material such as a solder, a sintered material (powder of a metal, a ceramic, or the like), an adhesive, or the like can be used. In addition, in the present embodiment, for example, aluminum, iron, copper, ceramic, or the like can be adopted as the material of the cooler main body 101, the refrigerant inlet portion 102, and the refrigerant outlet portion 103.

### (Effects of action)

In the power conversion device 1 according to the embodiment, the direct connection between the power semiconductor element 43 of the first substrate 40 and the gate drive circuit 52 of the second substrate 50 is only the connecting conductor 60. As a result, the heat generated throughout the first substrate 40 can be suppressed from being directly conducted to the second substrate 50. Further, since the second substrate 50 is disposed to face the first substrate 40 such that the second substrate 50 is separated from the first substrate 40 via a space on the first side, the connecting conductor 60, which electrically connects the first substrate 40 and the second substrate 50, can be kept short. Therefore, the wiring inductance of the connecting conductor 60 can be reduced while suppressing the conduction of heat from the power semiconductor element 43 to the gate drive circuit 52.

In addition, the power conversion device 1 according to the embodiment is provided with a block body 90 that is fixed to the main surface 30a, has a frame shape extending along the main surface 30a, and accommodates the first substrate 40 inside. Accordingly, for example, the number of parts can be reduced as compared with a case where the block body 90 and a case accommodating the first substrate 40 are individually provided. In addition, since the first substrate 40 is accommodated in the block body 90, the first substrate 40 can be kept safe.

In addition, in the power conversion device 1 according to the above embodiment, a mode of connection between the base substrate 30 and the second substrate 50 is only via the housing 10. As a result, since the heat generated in the power semiconductor element 43 passes through at least the housing 10 in the process of being conducted to the second substrate 50, the amount of the heat that is finally conducted is reduced. Therefore, a direct influence of heat from the first substrate 40 to the second substrate 50, that is, a temperature rise of the second substrate 50 can be suppressed.

In addition, in the power conversion device 1 according to the embodiment, the base substrate 30 is fixed to the first fixing surface 15c of the inner surface 15 of the housing 10, and the second substrate 50 is fixed to the second fixing surface 15e of the inner surface 15 of the housing 10. Accordingly, the above effect of action can be realized with a more specific configuration. Further, since the base substrate 30 and the second substrate 50 are fixed to the first fixing surface 15c and the second fixing surface 15e of the inner surface 15 of the housing 10, a path of heat conducted from the first substrate 40 to the second substrate 50 becomes longer. Therefore, a temperature rise of the gate drive circuit 52 of the second substrate 50 can be further suppressed.

In addition, the power conversion device 1 according to the embodiment further includes a cooler 100 that cools the base substrate 30 by coming into contact with only the back surface 30b facing the second side of the base substrate 30. As a result, since the base substrate 30 and the first substrate 40 are cooled, the amount of heat conducted from the first substrate 40 to the second substrate 50 via the housing 10 can be reduced. In addition, the base substrate 30 and the first substrate 40 can be intensively cooled without decreasing the cooling efficiency of the cooler 100.

### [Other embodiments]

Hitherto, the embodiments of the present disclosure have been described in detail with reference to the drawings. However, specific configurations are not limited to the configurations of each embodiment, and additions, omissions, and substitutions of configurations and other modifications can be made within the scope not departing from the concept of the present disclosure. In addition, the present disclosure is not limited by the embodiments, and is limited only by the claims.

In the above embodiment, the power conversion device 1 has been described by taking an inverter as an example. However, the power conversion device 1 is not limited to the inverter. The power conversion device 1 may be a device that performs power conversion using a power semiconductor element, such as a converter or a combination of an inverter and a converter.

In addition, in the above-described embodiment, the inner surface 15 of the housing 10 includes the first fixing surface 15c to which the base substrate 30 is fixed and the second fixing surface 15e to which the second substrate 50 is fixed. However, the configuration is not limited to this. Instead of a configuration where the inner surface 15 of the housing 10 includes the first fixing surface 15c and the second fixing surface 15e, the power conversion device 1 may include another member that is fixed to the inner surface 15 and forms the first fixing surface 15c and the second fixing surface 15e as the inner surface 15 of the housing 10. Accordingly, the housing 10 can be manufactured more easily, that is, the manufacturing cost of the housing 10 can be reduced, and the base substrate 30 and the second substrate 50 can be fixed in the housing 10 without being thermally directly connected to each other.

Further, in the above-described embodiment, the base substrate 30 and the second substrate 50 are fixed to the first fixing surface 15c and the second fixing surface 15e with bolts 110. However, the configuration is not limited to this. The base substrate 30 and the second substrate 50 may be fixed to the first fixing surface 15c and the second fixing surface 15e, for example, with an adhesive or the like.

In addition, in above-described embodiment, the main surface 30a and the back surface 30b of the base substrate 30, the first surface 41a and the second surface 41b of the first substrate main body 41, and the mounting surface 51a and the facing surface 51b of the second substrate main body 51 are not limited to a configuration where they are parallel to each other and back-to-back, and may be slightly inclined.

In addition, in above-described embodiment, each surface (bottom surface 15a, top surface 15g, side surface 17 on the input side, side surface on the output side, the first side surface 15b, the first fixing surface 15c, the second side surface 15d, the second fixing surface 15e, and the third side surface 15f) on the inner surface 15 of the housing 10 is not limited to the parallel and perpendicular arrangement relationships as described above, and may have an arrangement relationship that is slightly inclined from the parallel and perpendicular directions.

### [Appendix]

For example, the power conversion device according to the embodiments is understood as follows.
(1) The power conversion device 1 according to the first aspect includes a housing 10 which forms an accommodation space R therein, a base substrate 30 which is fixed to an inner surface 15 of the housing 10 such that the accommodation space R is partitioned into a first space R1 on a first side and a second space R2 on a second side, a first substrate 40 which is mounted on a part of a main surface 30a of the base substrate 30 facing the first side, and including a power semiconductor element 43, and a second substrate 50 which is disposed to face the base substrate 30 and the first substrate 40 such that the second substrate 50 is separated from the base substrate 30 and the first substrate 40 with a space on the first side, is fixed to the inner surface 15 of the housing 10, and includes a gate drive circuit 52 which inputs a gate voltage to the power semiconductor element 43 via a connecting conductor 60.
   According to the above configuration, the direct connection between the power semiconductor element 43 of the first substrate 40 and the gate drive circuit 52 of the second substrate 50 is only the connecting conductor 60. As a result, the heat generated throughout the first substrate 40 can be suppressed from being directly conducted to the second substrate 50. Further, since the second substrate 50 is disposed to face the first substrate 40 such that the second substrate 50 is separated from the first substrate 40 via a space on the first side, the connecting conductor 60, which electrically connects the first substrate 40 and the second substrate 50, can be kept short.
(2) The power conversion device 1 according to the second aspect, which is the power conversion device 1 in (1), further includes a block body 90 which is fixed to the main surface 30a, and having a frame shape extending along the main surface 30a to accommodate the first substrate 40 inside, in which the second substrate 50 is provided to be separated from the block body 90 with a space on the first side.
   According to the above configuration, for example, the number of parts can be reduced as compared with a case where the block body 90 and the case accommodating the first substrate 40 are individually provided. In addition, since the first substrate 40 is accommodated in the block body 90, the first substrate 40 can be kept safe.
(3) The power conversion device 1 according to the third aspect, which is the power conversion device 1 in (1) or (2), in which the base substrate 30 and the second substrate 50 are connected only via the housing 10.
   According to the above configuration, since the heat generated in the power semiconductor element 43 passes through at least the housing 10 in the process of being conducted to the second substrate 50, the amount of the heat that is finally conducted is reduced.
(4) The power conversion device 1 according to the fourth aspect, which is the power conversion device 1 in any one of (1) to (3), in which the inner surface 15 includes a first fixing surface 15c that faces the first side, and a second fixing surface 15e that faces the first side on the first side with respect to the first fixing surface 15c, the base substrate 30 is fixed to the first fixing surface 15c, and the second substrate 50 is fixed to the second fixing surface 15e.
   According to the above configuration, the above effects can be realized with a more specific configuration. Further, since the base substrate 30 and the second substrate 50 are fixed to the first fixing surface 15c and the second fixing surface 15e of the inner surface 15 of the housing 10, a path of heat conducted from the first substrate 40 to the second substrate 50 becomes longer.
(5) The power conversion device 1 according to the fifth aspect, which is the power conversion device 1 in any one of (1) to (4), further includes a cooler 100 which is provided in the second space R2 and is in contact with only a back surface 30b of the base substrate 30 facing the second side to cool the base substrate 30.

According to the above configuration, since the base substrate 30 and the first substrate 40 are cooled, the amount of heat conducted from the first substrate 40 to the second substrate 50 via the housing 10 can be reduced. In addition, the base substrate 30 and the first substrate 40 can be intensively cooled without decreasing the cooling efficiency of the cooler 100.

### Industrial Applicability

According to the power conversion device of the present disclosure, it is possible to reduce a wiring inductance of a connecting conductor while suppressing conduction of heat from the power semiconductor element to the gate drive circuit.

### Reference Signs List

- 1:: power conversion device
- 10:: housing
- 11:: external input conductor
- 12:: rectification unit
- 13:: power conversion unit
- 14:: relay conductor
- 14a:: first relay conductor
- 14b:: second relay conductor
- 15:: inner surface
- 15a:: bottom surface
- 15b:: first side surface
- 15c:: first fixing surface
- 15d:: second side surface
- 15e:: second fixing surface
- 15f:: third side surface
- 15g:: top surface
- 17:: side surface on input side
- 20:: power module
- 30:: base substrate
- 30a:: main surface
- 30b:: back surface
- 40:: first substrate
- 41:: first substrate main body
- 41a:: first surface
- 41b:: second surface
- 42:: power conversion circuit
- 43:: power semiconductor element
- 50:: second substrate
- 51:: second substrate main body
- 51a:: mounting surface
- 51b:: facing surface
- 52:: gate drive circuit
- 60:: connecting conductor
- 61:: first connection portion
- 62:: second connection portion
- 70:: input conductor
- 71:: first input conductor
- 72:: second input conductor
- 80:: output conductor
- 90:: block body
- 100:: cooler
- 101:: cooler main body
- 102:: refrigerant inlet portion
- 103:: refrigerant outlet portion
- 110:: bolt
- 112:: fastening hole
- P:: potting space
- R:: accommodation space
- R1:: first space
- R2:: second space

## Claims

1. A power conversion device comprising:
a housing which forms an accommodation space therein;
a base substrate which is fixed to an inner surface of the housing such that the accommodation space is partitioned into a first space on a first side and a second space on a second side;
a first substrate which is mounted on a part of a main surface of the base substrate facing the first side, and including a power semiconductor element; and
a second substrate which is disposed to face the base substrate and the first substrate such that the second substrate is separated from the base substrate and the first substrate with a space on the first side, is fixed to the inner surface of the housing, and includes a gate drive circuit which inputs a gate voltage to the power semiconductor element via a connecting conductor.

2. The power conversion device according to Claim 1, further comprising:
a block body which is fixed to the main surface, and having a frame shape extending along the main surface to accommodate the first substrate inside,
wherein the second substrate is provided to be separated from the block body with a space on the first side.

3. The power conversion device according to Claim 1 or 2,
wherein the base substrate and the second substrate are connected only via the housing.

4. The power conversion device according to Claim 1 or 2, wherein the inner surface includes
a first fixing surface that faces the first side, and
a second fixing surface that faces the first side on the first side with respect to the first fixing surface,
the base substrate is fixed to the first fixing surface, and
the second substrate is fixed to the second fixing surface.

5. The power conversion device according to Claim 1 or 2, further comprising:
a cooler which is provided in the second space and is in contact with only a back surface of the base substrate facing the second side to cool the base substrate.
